# EUROPÄISCHE PATENTSCHRIFT

(11) **EP 1 927 275 B1**
(45) Veröffentlichungstag und Bekanntmachung des Hinweises auf die Patenterteilung: **29.09.2010**
(21) Anmeldenummer: 06793003.2
(22) Anmeldetag: 25.08.2006
(51) Int. Cl.: H05K 3/12, B41N 1/24

(54) **DRUCKSCHABLONE EINES SMT-PROZESSES UND VERFAHREN ZU IHRER BESCHICHTUNG**
PRINTING TEMPLATE OF AN SMT PROCESS AND METHOD OF COATING IT
GABARIT D'IMPRESSION D'UN PROCESSUS SMT ET SON PROCEDE DE REVETEMENT

(30) Priorität: 22.09.2005 DE 102005045350
(43) Veröffentlichungstag der Anmeldung: 04.06.2008
(73) Patentinhaber: SIEMENS AKTIENGESELLSCHAFT, 80333 München (DE)
(72) Erfinder: ZEININGER, Heinrich, 90587 Obermichelbach (DE); ZRENNER, Rudolf, 92224 Amberg (DE)
(86) Internationale Anmeldenummer: PCT/EP2006/065666
(87) Internationale Veröffentlichungsnummer: WO 2007/033882

(56) Entgegenhaltungen:
- DE-A1- 10 231 698
- DE-C1- 4 122 743
- US-A- 4 803 110
- US-A1- 2002 036 686
- US-A1- 2003 222 125
- US-A1- 2004 011 228
- US-A1- 2004 043 161
- US-A1- 2004 089 171
- US-B1- 6 777 070

## Beschreibung

Die Erfindung bezieht sich auf ein Verfahren zur Beschichtung einer Druckschablone eines SMT-Prozesses und eine Druckschablone, die in ihrem metallischen Schablonenkörper einer vorbestimmten Druckstruktur entsprechende Ausnehmungen aufweist, durch welche hindurch ein Druckmaterial auf eine an die Druckschablone von unten anzufügende Platte aufzubringen ist. Eine entsprechende Metallschablone geht z.B. aus der DE 44 38 281 C1 hervor.

Entsprechende Druckschablonen werden bevorzugt für SMT (Surface Mounted Technology)-Prozesse verwendet, bei denen Leiterplatten mit elektronischen Bauteilen zu bestücken sind. Hierzu werden die Leiterplatten zunächst mittels Schablonendrucktechnik gemäß einer vorgegebenen Druckstruktur an bestimmten Stellen mit einer Druck- oder Lotpaste oder mit einem Kleber versehen. Dabei wird die Lotpaste bzw. die Kleberpaste mittels einer so genannten Rakel durch der Druckstruktur entsprechende Ausnehmungen eines metallischen Schablonenkörpers hindurch auf die jeweilige Leiterplatte aufgebracht. Es ergeben sich so dort Lötpastendepots oder Klebepunkte, so genannte Pads, an welchen die elektronischen Bauteile z.B. mittels einer Bestückungsmaschine angesetzt und anschließend fixiert werden.

Eine entsprechende, als Siebdruck-Sieb bezeichnete Druckschablone und ein Verfahren zu deren Herstellung sind aus der eingangs genannten DE 44 38 281 C1 bekannt. Das wirksame Siebdruck-Sieb besteht dabei im Wesentlichen aus einem formsteifen Rahmen, auf den ein feines Metalldrahtgewebe unter Vorspannung aufgeklebt ist. In einem mittleren Bereich dieses Metalldrahtgewebes ist eine das Druckmuster aus den Ausnehmungen aufweisende dünnwandige Metallschablone befestigt. Eine Herstellung einer derartigen metallischen Druckschablone ist auch der US 2,421,607 A zu entnehmen.

Mit fortschreitender Miniaturisierung der elektronischen Bauteile geht auch eine entsprechende Verkleinerung der Ausnehmungen in den Druckschablonen einher. Hierbei ergibt sich die Gefahr, dass Löt- oder Klebepunkte oder Pastendepots an den durch das jeweilige Druckmuster bestimmten Öffnungsrändern oder- wänden des als Schablonenmaterial verwendeten Metalls anhaften, so dass die entsprechenden Ausnehmungen sukzessive zuwachsen können. Dies wiederum hat häufig ein Aus- oder Einreißen der Außenränder der auf die Leiterplatte aufgebrachten Pads beim Abheben der Druckschablone zur Folge. D.h., die Anforderungen hinsichtlich eines gewünschten konturenscharfen Druckbildes auf der Leiterplatte können dann nicht mehr erfüllt werden.

Aufgrund dieser Gefahr sieht man sich häufig gezwungen, die Druckqualität über besondere Reinigungszyklen zu verbessern. Eine Reinigung bedeutet jedoch eine Prozessunterbrechung und damit eine negative Beeinflussung der Produktivität im Prozess. Eine weitere Möglichkeit zu einer Fehlerreduzierung wird darin gesehen, die metallische Druckschablone durch Elektropolieren im Bereich ihrer Ausnehmungen zu veredeln. Dies führt zu einer entsprechenden Verteuerung der Herstellung der Schablonen. Man hat auch versucht, durch eine andere Wahl des Schablonenmaterials wie z.B. Glas [vgl. z.B. DE 101 05 329 A1] die genannten Schwierigkeiten zu umgehen. Dieses Material ermöglicht jedoch nur verhältnismäßig große Ausnehmungen.

Die DE 102 31 698 A1 beschreibt die Beschichtung von Druckschablonen mittels Siloxanen unter Verwendung eines Niederdruck-Plasmaverfahrens. Durch dieses Verfahren wird eine dünne Schicht des Siloxans auf einer Oberfläche aufgebracht, ohne dass das Siloxan an sich eine Veränderung erfährt.

Aus der US 6,777,070 B1 ist eine antireflektive Beschichtung eines transpartenten Materials bekannt, das ein Copolymer einer Methacrylat-Komponente mit einer Fluorenstruktur umfasst.

Aus der US 2003/222125 ist eine Druckschablone eines SMT-Prozesses bekannt, wobei der Grundkörper mit einer Beschichtung, die beispielsweise Parylen, auch bekannt als Poly-paraxylylen, ist.

Die Druckschrift US 2004/043161 A1 betrifft lösungsmittelarme Sol-Gel-Systeme, die als Korrosionsschutz für Leichtmetalle und Stahl oder auch als Drucktinten oder Lackzusätze verwendet werden können.

Die Druckschrift US 2002/0036686 beschreibt die Beschichtung eines thermischen Druckkopfes mittels eines Films, der hauptsächlich aus Siliciumdioxid und Fluoralkylgruppen besteht.

Die Druckschrift DE 41 22 743 C1 betrifft Beschichtungsmassen, die mittels UV- oder UV/IR ausgehärtet werden müssen.

Der Erfindung liegt deshalb die Aufgabe zugrunde, eine Beschichtung für eine Druckschablone eines SMT-Prozesses, wie z.B. für eine Leiterplattenbestückung oder Baugruppenherstellung mit verbesserten Eigenschaften zur Verfügung zu stellen.

Diese Aufgabe wird mit den in Anspruch 1 und 4 angegebenen Maßnahmen gelöst. Demgemäß ist Gegenstand der Erfindung ein Verfahren zur Beschichtung einer Druckschablone eines SMT-Prozesses, die in ihrem metallischen Schablonenkörper einer vorbestimmten Druckstruktur entsprechende Ausnehmungen aufweist, durch welche hindurch ein Druckmaterial auf eine an die Druckschablone von unten anzufügende Platte aufzubringen ist, gekennzeichnet durch einen Sol-Gel-Prozess, bei dem ein Formmaterial eines metallalkoxidischen Beschichtungsmaterials nasschemisch auf den metallischen Schablonenkörper (2a) aufgebracht wird und anschließend thermisch gehärtet wird, wodurch er mit einer dünnen Beschichtung (6) aus einem thermisch stabilen, metallalkoxidischen hybridpolymeren Beschichtungsmaterial mit netzwerkartigem Aufbau versehen wird, wobei das metallalkoxidische Beschichtungsmaterial wenigstens einen organischen Anteil aufweist, der durch eine Alkyl-Gruppe oder eine Aryl-Gruppe oder eine Siloxan-Gruppe gebildet ist, wodurch dessen Oberflächenenergie reduziert ist. Außerdem ist Gegenstand der Erfindung eine Druckschablone eines SMT-Prozesses, die in ihrem metallischen Schablonenkörper einer vorbestimmten Druckstruktur entsprechende Ausnehmungen (3) aufweist, durch welche hindurch ein Druckmaterial auf eine an die Druckschablone von unten anzufügende Platte aufzubringen ist, dadurch gekennzeichnet, dass der metallische Schablonenkörper (2a) eine dünne, kleiner 10 µm dicke Beschichtung (6) aus einem thermisch stabilen, metallalkoxidischen hybridpolymeren Material mit netzwerkartigem Aufbau hat, wobei der netzwerkartige Aufbau organische und anorganische Komponenten umfasst.

Durch dieses Verfahren ist es möglich, dass die Druckschablone so ausgestaltet ist, dass ihr metallischer Schablonenkörper mit einer dünnen Beschichtung aus einem metallalkoxidischen Beschichtungsmaterial versehen ist, dessen Oberflächenenergie durch chemische Anbindung von wenigstens einem organischen Anteil reduziert ist.

Es zeigt sich, dass bei metallischen Schablonenkörpern eine Verwendung von reinen metalloxidischen Materialien für die Beschichtung nur geringen Erfolg hat. Es wurde nun erkannt, dass man durch eine gezielte chemische Anbindung von organischen Anteilen (Gruppen bzw. Molekülketten) an ein metallalkoxidisches Material, d.h. mit Organoalkoxidverbindungen eine deutliche Reduzierung der Oberflächenenergie (gegenüber dem unmodifizierten metalloxidischen Beschichtungsmaterial) erreichen kann. Die Folge davon ist eine entsprechende Verminderung der Anhaftung des über die Ausnehmungen der Druckschablone auf darunter liegende Leiterplatten aufzubringenden, zumeist pastösen Lot- oder Klebematerials an dem Schablonenkörper, insbesondere an den Wänden seiner Ausnehmungen Das so genannte Auslöseverhalten insbesondere der Ausnehmungen der metallischen Schablonenkörper kann also bei einem Druckprozess (Aufbringen des Druckmaterials) mit dem niederenergetischen Beschichtungsmaterial verbessert werden. Damit verbunden ist der Vorteil, dass Ausnehmungen mit sehr geringen Abmessungen eingesetzt werden können, ohne dass die Gefahr eines Zuwachsens gegeben ist.

Eine solche Beschichtung im Bereich der Schablonenausnehmungen vereinigt zwei positive Eigenschaften: Die Ausnehmungen behalten ihre Ausdehnung, weil nur dünne Schichten, insbesondere im Nanometerbereich, erforderlich sind. Außerdem werden die Wandungen der Ausnehmungen durch das Beschichtungsmaterial quasi "geglättet" oder, was dieselbe positive Wirkung hat, mit einer regelmäßigen Strukturierung versehen.

Vorteilhafte Ausgestaltungen der erfindungsgemäßen Druckschablone gehen aus den von Anspruch 1 abhängigen Ansprüchen hervor.

So kann vorteilhaft das metallalkoxidische Beschichtungsmaterial wenigstens ein Alkoxid eines oder mehrerer der Elemente Aluminium (Al), Silizium (Si), Tantal (Ta), Titan (Ti), Zirkon (Zr), Hafnium (Hf) oder Yttrium (Y) zumindest enthalten. Mit entsprechenden Metallalkoxiden lassen sich dann besonders geeignete, thermisch stabile Beschichtungsmaterialien in Form von so genannten Hybrid-Polymeren (mit dem Alkoxid und einem organischen Netzwerk) ausbilden.

Der organische Anteil an solchen Hybrid-Polymeren kann dabei bevorzugt durch eine Alkyl-Gruppe oder Aryl-Gruppe oder eine Siloxan-Gruppe gebildet sein. Außerdem wird durch die besondere Auswahl des Beschichtungsmaterials ein Zuwachsen bzw. Zusetzen der Ausnehmungen wegen der das pastöse Material abweisenden Eigenschaft des Schichtmaterials verhindert oder zumindest stark reduziert.

Wird ein metallalkoxidisches Beschichtungsmaterial vorgesehen, bei dem zusätzlich ein fluorhaltiger Anteil, z.B. in Form einer Fluor-Aryl-Gruppe, eingebaut wird, so wird damit die Wasser und/oder Öl abweisende Eigenschaft der Beschichtung noch weiter gefördert.

Diese abweisende Eigenschaft ist auf alle Fälle zu gewährleisten, wenn die Druckschablone eine Oberflächenenergie der Beschichtung von unter 20 mN/m (MilliNewton pro Meter), vorzugsweise von unter 15 mN/m aufweist.

Wegen der erfindungsgemäßen Beschichtung ist es vorteilhaft möglich, dass die maximale Ausdehnung wenigstens einer der Ausnehmungen so gering ist, dass sie zwischen 200 µm und 500 µm liegt.

Ferner kann vorteilhaft die Druckschablone eine Dicke der Beschichtung unter 10 µm, vorzugsweise unter 5 µm, aufweisen. Geringe Dicken führen zu einer entsprechenden Begrenzung der Gefahr eines Anhaftens von pastösen Druckmaterialresten.

Bevorzugt kann das aufzubringende Druckmaterial ein pastöses Lotmaterial oder Klebematerial sein.

Besonders vorteilhaft lässt sich eine Beschichtung einer Druckschablone mittels eines Sol-Gel-Prozesses herstellen, bei dem ein Vormaterial des Beschichtungsmaterials nasschemisch auf den metallischen Schablonenkörper aufgebracht und anschließend thermisch ausgehärtet wird. Dabei kann das Vormaterials insbesondere durch Sprühen oder Tauchen oder Fluten oder Rollen oder Streichen aufgebracht werden.

Ein weiteres vorteilhaftes Verfahren zur Beschichtung einer Druckschablone ist dadurch gekennzeichnet, dass ein CVD(Chemical Vapor Deposition)-Prozess mit Plasma-Unterstützung unter Niederdruck oder Atmosphärendruck angewandt wird.

Beide Beschichtungsverfahren führen vorteilhaft zu insbesondere an den Wänden der Ausnehmungen praktisch nicht-haftenden Beschichtungen. Durch Einbau von fluorhaltigen Anteilen in das metallalkoxidische Material kann vorteilhaft die Wasser und/oder Öl abweisende Wirkung der Beschichtung noch weiter gefördert werden.

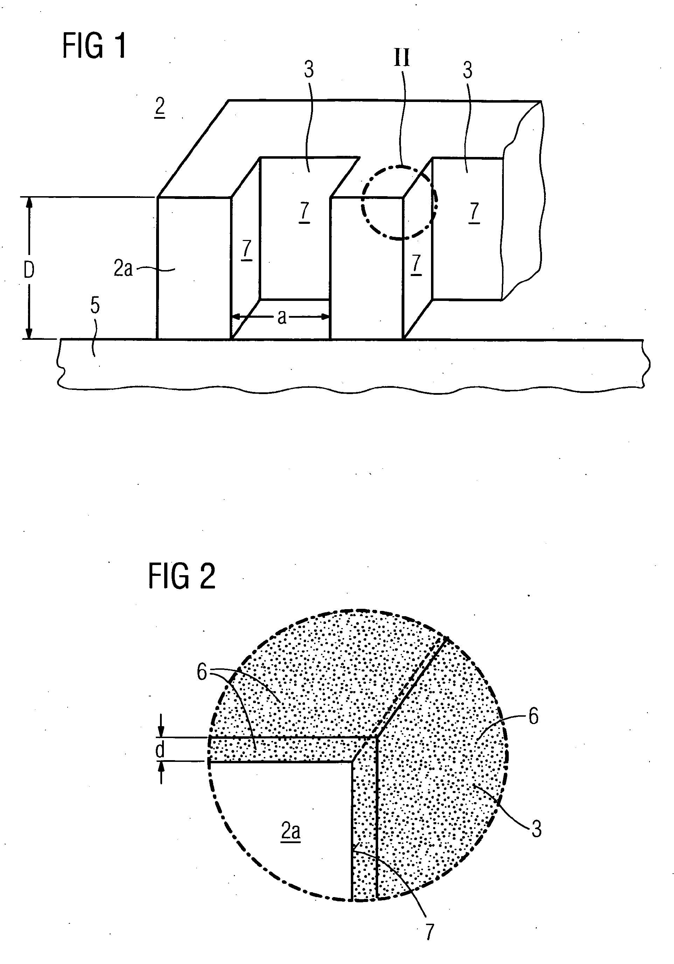

Zur weiteren Erläuterung der Erfindung wird nachfolgend auf die Zeichnung Bezug genommen, anhand derer ein bevorzugtes Ausführungsbeispiel veranschaulicht ist. Dabei zeigen in stark schematisierter, nicht-maßstabgetreuer Darstellung deren Figur 1 den Aufbau einer erfindungsgemäß beschichteten Druckschablone, während aus deren Figur 2 ein vergrößerter Ausschnitt aus einem Bereich dieser Schablone hervorgeht. In den Figuren sind entsprechende Teile mit denselben Bezugszeichen versehen.

Bei der in den Figuren in Schnittaufsicht angedeuteten, allgemein mit 2 bezeichneten Druckschablone wird von an sich bekannten Ausführungsformen solcher Schablonen ausgegangen. Ihr metallischer Schablonenkörper 2a besteht bevorzugt aus einem Stahl wie insbesondere einem Edelstahl, z.B. einem CrNi-Stahl, oder aus Ni oder einer anderen Ni-Legierung. Dessen Dicke D liegt häufig zwischen 100 und 5000 µm. In den Schablonenkörper 2a sind in bekannter Weise, z.B. mittels Lasertechnologie oder galvanoplastischer Verfahren, Ausnehmungen 3 oder sonstige Durchbrüche (Aperturen) eingearbeitet. Die maximale Abmessung a dieser Ausnehmungen liegt im Allgemeinen zwischen 200 µm und 500 µm, beispielsweise bei etwa 400 µm. Sie hängt von der gewünschten Größe des auf einer darunter liegenden Leiterplatte 5 aufzubringenden Pads (Kontaktierungsfläche) aus einem an sich bekannten Druckmaterial wie insbesondere einer bekannten Lot- oder Klebepaste ab. Hierzu wird die Druckschablone 2 auf die Leiterplatte 5 aufgedrückt. Von der offenen Seite der Ausnehmungen 3 her wird dann die Lot- oder Klebepaste mittels einer über die freie Oberfläche der Druckschablone hinweg streichenden Rakel eingebracht.

Damit sich nach diesem Druckprozess beim anschließenden Abheben der Druckschablone 2 von der Leiterplatte 5 die Lot- oder Klebepaste gut von der Druckschablone, insbesondere von den Wänden ihrer Ausnehmungen 3 lösen kann (so genanntes Auslöseverhalten), ist diese erfindungsgemäß mit einer besonderen funktionellen Beschichtung versehen. Dabei wird davon ausgegangen, dass das Abreißverhalten an den Wänden 7 der Ausnehmungen 3 der Schablone durch Beschichtung der betroffenen Oberflächen mit einem Beschichtungsmaterial unterdrückt werden kann, das zu einer Reduzierung der Oberflächenenergie auf unter 20 mN/m, vorzugsweise auf unter 15 mN/m, führt. Als Beschichtungsmaterial eignen sich hierfür thermisch stabile metallalkoxidische Materialien [vgl. z.B. "Römpp Chemie Lexikon", 9.Auflage 1989, C.Thieme Verlag Stuttgart (DE), Seite 115 bzw. 106], die chemisch mit organischen Gruppen verbunden sind, so genannte Organometallalkoxidverbindungen. Diese Materialien lassen sich beispielsweise durch ein Sol-Gel-Verfahren oder über einem reaktiven Plasmaabscheidungsprozess unter Verwendung von Niederdruck- oder Atmosphärendruckplasma herstellen.

Nachfolgend wird auf diese zwei vorteilhaften Verfahren näher eingegangen, mit denen eine erfindungsgemäße Beschichtung erfolgen kann. Dabei sind nicht näher beschriebene Details bzw. Schritte dieser Verfahren allgemein bekannt:

### I. Beschichtungen nach dem Sol-Gel-Verfahren

Eine in Figur 2 allgemein mit 6 bezeichnete Beschichtung mit Antihafteigenschaften insbesondere bezüglich der Seitenwände 7 der Ausnehmungen 3 besitzt eine netzwerkartigen Aufbau (Struktur) mit organischen und anorganischen Komponenten des Beschichtungsmaterials. Zur Ausbildung entsprechender Beschichtungen verwendet man als Vormaterialien bzw. Ausgangsstoffe (so genannte "Precursors") Metallalkoxide, die mit organischen Anteilen bzw. Seitenketten chemisch modifiziert sind. Besonders geeignet sind Metallalkoxide der Elemente Al, Si, Ta, Ti, Zr, Hf, Y. Als ein entsprechendes, bevorzugtes Ausführungsbeispiel sei ein Si-Alkoxid gewählt, das die folgende Struktur aufweist:

Xn-Si-(OR)4-n.

Dabei sind
X = eine organische Modifikation des Alkoxides,
R = eine Alkyl-Gruppe wie z.B. eine Methyl oder Ättylgruppe, oder eine Aryl-Gruppe wie z.B. eine Phenylgruppe [vgl. z.B. "Römpp Chemie Lexikon", 9.Auflage 1989, C.Thieme Verlag Stuttgart (DE), Seite 115 bzw. 260],
O = Sauerstoff.
X kann eine reaktive oder nicht-reaktive Seitenkette sein. Die Herstellung der Beschichtung erfolgt durch Hydrolyse und Kondensation der modifizierten Metallalkoxide.

Die organische Modifikation des Metallalkoxides beeinflusst signifikant die Eigenschaften der Beschichtung. So reduzieren hydrophobe Seitenketten X wie z.B. Alkylketten, Arylgruppen, Fluoralkylketten oder Siloxan-Gruppen drastisch die Oberflächenenergie der Beschichtung und bewirken einen wasser- (hydrophoben) und/oder ölabweisenden (oleophoben) Effekt.

Selbstverständlich kann das vorstehend erwähnte, insbesondere hydrophobe Sol-Gel-basierte Beschichtungsmaterial noch durch den Einbau von oberflächenbehandelten nano- oder mikroskaligen Partikeln weiter modifiziert werden, um so z. B. die mechanische Abriebbeständigkeit oder die Korrosionsbeständigkeit zu verbessern oder besondere katalytische Effekte zu erhalten. So können beispielsweise durch Einbau von katalytisch wirksamen Komponenten z.B. in Form von nano- oder mikroskaligen Katalysatorpartikeln kohlenstoffhaltige Ablagerungen thermooxidativ degradiert werden (so genannte aktive Beschichtung).

Die Precursormaterialien werden bei dem erwähnten Sol-Gel-Beschichtungsverfahren über konventionelle, insbesondere nasschemische Verfahren wie z.B. Sprühen oder Tauchen oder Fluten oder Rollen oder Streichen auf den Schablonenkörper 2 aus dem Metall aufgetragen. Die Beschichtungen werden anschließend thermisch ausgehärtet, typischerweise in einem Temperaturbereich zwischen Raumtemperatur bis etwa 300°C. Höhere Härtungstemperaturen von z.B. über 400°C sind im Allgemeinen weniger geeignet, weil sie häufig zu glasartigen Überzügen mit geringerer Haftwirkung führen. Bei thermisch instabilen Seitenketten X besteht die Gefahr einer Zersetzung bei hohen Härtetemperaturen. So zeigen z.B. fluorhaltige Seitenketten eine für Hochtemperaturanwendungen nicht ausreichende thermische Stabilität. Aushärtetemperaturen und/oder Einsatztemperaturen von 250°C oder höher führen in diesem Fall zu einer Zersetzung der Seitenkette und damit zu einem Abbau des hydrophoben Effektes der Beschichtung. Für Niedertemperaturanwendungen jedoch, wie sie im Schablonendruck vorteilhaft vorgesehen sein können, kann durch fluorhaltige Seitenketten X die Wasser und Öl abweisende Wirkung noch gesteigert werden. Kurzkettige Seitengruppen wie z.B. X = Methyl-Gruppen oder Aryl-Gruppen zeigen demgegenüber eine ausreichende thermische Stabilität bis in den genannten Hochtemperaturbereich.

Die resultierende Schichtdicke d der Beschichtung liegt beispielsweise für oliophobe Schichtsysteme vorteilhaft im Bereich unter 1 µm, während für kratzfeste Systeme größere Dicken d im Bereich von über 5 µm bevorzugt zu wählen sind. Im Allgemeinen sind resultierende Schichtdicken d im Bereich von 1 bis 5 µm vorteilhaft und auch ausreichend.

### II. Beschichtungen nach einem CVD-Prozess

Erfindungsgemäße Antihaft-Beschichtungen 6 auf Metallalkoxid-Basis können auch über Plasma unterstützte reaktive CVD(Chemical Vapor Deposition)-Prozesse generiert werden. Hierzu können insbesondere reaktive Silanverbindungen eingesetzt werden wie z. B. Hexamethyldisiloxan (HMDSO). Ein Einbau von Fluorkomponenten in die Beschichtung ist durch Zugabe geeigneter Fluorsilan-Verbindungen möglich. Die Applikation erfolgt in bekannter Weise z. B. in einer Niederdruck-CVD-Anlage. Eine Beschichtung des als Substrates dienenden metallischen Schablonenkörpers 2a innerhalb von Anlagen über Atmosphärendruckplasmen ist ebenfalls möglich. Ähnlich wie bei Sol-Gel-Beschichtungen ist auch hier eine Effektstabilität wie insbesondere eine hydrophobe Eigenschaft von CVD-Beschichtungen mit Fluor-haltigen Komponenten aufgrund der thermischen Instabilität von Fluor-Gruppen bis höchstens 250°C gegeben. Für Hochtemperaturanwendungen sind folglich Fluor freie Silanverbindungen bevorzugt zu verwenden.

Nach den vorstehend geschilderten Prozessen erstellte Testbeschichtungen 6 wurden auf bekannten Schablonenkörpern 2a durchgeführt. Die Beschichtungen wurden mit verschiedenen Technologien wie z.B. durch Tauchen, Sprühen, Rollen appliziert und bei Temperaturen unter 200°C ausgehärtet. Dabei wurde die Oberseite der Schablone während der Applikation mit einer leicht abnehmbaren Folie abgedeckt. Bei Tauchverfahren wird die Folie dabei leicht unterwandert, was tolerierbar ist. Mit Spray- oder Rollverfahren wird weniger Material aufgebracht; dadurch wird die Folie weniger belastet. Die Oberfläche, über die das Lot gerakelt wird, wird vorteilhaft bei diesen Prozessen nicht verunreinigt bzw. beschichtet. Insbesondere werden die Wände 7 der Ausnehmungen nicht beschichtet.

Der Antihaft-Effekt wurde durch Bestimmung der Kontaktwinkel nachgewiesen. Der Effekt ist auch nach mehreren Reinigungsschritten mit und ohne Spülmittel stabil vorhanden. Vorteilhaft führt die erfindungsgemäße Beschichtung auch zu einer geringeren Oberflächenrauhigkeit. Damit ist beim Stand der Technik das zu beobachtende Problem der Rauhigkeit der Seitenwände und das damit verbundene schlechte Auslöseverhalten bezüglich der verwendeten Pasten nicht mehr gegeben.

## Patentansprüche

1. Verfahren zur Beschichtung einer Druckschablone eines SMT-Prozesses, die in ihrem metallischen Schablonenkörper einer vorbestimmten Druckstruktur entsprechende Ausnehmungen aufweist, durch welche hindurch ein Druckmaterial auf eine an die Druckschablone von unten anzufügende Platte aufzubringen ist, **gekennzeichnet durch** einen Sol-Gel-Prozess, bei dem ein Formmaterial eines metallalkoxidischen Beschichtungsmaterials nasschemisch auf den metallischen Schablonenkörper (2a) aufgebracht wird und anschließend thermisch gehärtet wird, wodurch er mit einer dünnen Beschichtung (6) aus einem thermisch stabilen, metallalkoxidischen hybridpolymeren Beschichtungsmaterial mit netzwerkartigem Aufbau versehen wird, wobei das metallalkoxidische Beschichtungsmaterial wenigstens einen organischen Anteil aufweist, der **durch** eine Alkyl-Gruppe oder eine Aryl-Gruppe oder eine Siloxan-Gruppe gebildet ist, wodurch dessen Oberflächenenergie reduziert ist.

2. Verfahren nach Anspruch 1, **dadurch gekennzeichnet, dass** das aufzubringende Druckmaterial ein pastöses Lotmaterial oder Klebematerial ist.

3. Verfahren nach einem der vorangehenden Ansprüche, **dadurch gekennzeichnet, dass** das Aufbringen des Formmaterials durch Sprühen oder Tauchen oder Fluten oder Rollen oder Streichen erfolgt.

4. Druckschablone eines SMT-Prozesses, die in ihrem metallischen Schablonenkörper einer vorbestimmten Druckstruktur entsprechende Ausnehmungen (3) aufweist, durch welche hindurch ein Druckmaterial auf eine an die Druckschablone von unten anzufügende Platte aufzubringen ist, **dadurch gekennzeichnet, dass** der metallische Schablonenkörper (2a) eine dünne, kleiner 10 µm dicke Beschichtung (6) aus einem thermisch stabilen, metallalkoxidischen hybridpolymeren Material mit netzwerkartigem Aufbau hat, wobei der netzwerkartige Aufbau organische und anorganische Komponenten umfasst.

5. Druckschablone nach Anspruch 4, **dadurch gekennzeichnet, dass** die Beschichtung (6) eine Oberflächenenergie von unter 20 mN/m aufweist.

6. Druckschablone nach einem der vorangehenden Ansprüche 4 oder 5, **dadurch gekennzeichnet, dass** die maximale Ausdehnung (a) wenigstens einer der Ausnehmungen (3) der Druckschablone zwischen 200 µm und 500 µm liegt.

7. Druckschablone nach einem der vorangehenden Ansprüche 4 bis 6, **dadurch gekennzeichnet, dass** die Dicke (d) der Beschichtung (6) unter 5 µm, liegt.

8. Druckschablone nach einem der vorangehenden Ansprüche 4 bis 7, **gekennzeichnet durch** einen Schablonenkörper (2a) aus einem Stahl oder aus Nickel(Ni) oder einer Nickel-Legierung.

9. Druckschablone nach einem der vorstehenden Ansprüche 4 bis 8, **dadurch gekennzeichnet, dass** die netzwerkartige Beschichtung einen organischen Anteil am Hybrid-Polymer hat, der ausgewählt ist aus der Gruppe umfassend die Alkyl-, Aryl-, und Siloxangruppe.

10. Druckschablone nach einem der vorstehenden Ansprüche 4 bis 9, **dadurch gekennzeichnet, dass** das metallalkoxidische Beschichtungsmaterial wenigstens ein Alkoxid eines oder mehrerer der Elemente Aluminium (A1), Silicium (Si), Tantal (Ta), Titan (Ti), Zirkon (Zr), Hafnium (Hf) oder Yttrium (Y) umfasst.

11. Druckschablone nach einem der Ansprüche 4 bis 10, **dadurch gekennzeichnet, dass** in dem metallalkoxidischen hybridpolymeren Beschichtungsmaterial fluorhaltige Anteile wie Fluoralkylketten eingebaut sind.

12. Druckschablone nach einem der vorstehenden Ansprüche 4 bis 11, wobei das Beschichtungsmaterial durch den Einbau von oberflächenbehandelten nano- oder mikroskaligen Partikeln modifiziert ist.

13. Druckschablone nach einem der vorstehenden Ansprüche, 4 bis 12, wobei das Beschichtungsmaterial durch den Einbau von nicht-oberflächenbehandelten Katalysatorpartikeln modifiziert ist.

## Claims

1. Method for coating a printing template of an SMT process, which has clearances corresponding to a predetermined printing structure in its metallic template body, through which clearances, a printing material is to be applied to a plate that is to be joined onto the printing template from below, **characterised by** a sol-gel process, in which a moulding material of a metal-alkoxide coating material is wet chemically applied to the metallic printing template (2a) and is then thermally hardened, as a result of which it is provided with a thin coating (6) comprising a thermally stable metal-alkoxide hybrid polymer coating material having a network-type structure, with the metal-alkoxide coating material having at least one organic component, which is formed by an alkyl group or an aryl group or a siloxane group, as a result of which its surface energy is reduced.

2. Method according to claim 1, **characterised in that** the printing material to be applied is a paste-like soldering material or adhesive material

3. Method according to one of the preceding claims, **characterised in that** the moulding material is applied by means of spraying or dipping or flooding or rolling or coating.

4. Printing template of an SMT process, which has clearances corresponding to a predetermined printing structure in its metallic template body, through which clearances a printing material is to be applied to a plate that is to be joined onto the printing template from below, **characterised in that** the metallic template body (2a) has a thin, small 10 µm thick coating (6) comprising a thermally stabile, metal-alkoxide hybrid polymer material with a network-type structure, with the network-type structure including organic and inorganic components.

5. Printing template according to claim 4, **characterised in that** the coating (6) has a surface energy of below 20 mN/m.

6. Printing template according to one of the preceding claims 4 or 5, **characterised in that** the maximum extension (a) of at least one of the clearances (3) of the printed template lies between 200 µm and 500 µm.

7. Printing template according to one of the preceding claims 4 to 6, **characterised in that** the thickness (d) of the coating (6) lies below 5 µm.

8. Printing template according to one of the preceding claims 4 to 7, **characterised by** a template body (2a) made of steel or nickel (Ni) or a nickel alloy.

9. Printing template according to one of the preceding claims 4 to 8, **characterised in that** the network-type coating has an organic component on the hybrid polymer, which is selected from the group comprising the alkyl, aryl and siloxane groups.

10. Printing template according to one of the preceding claims 4 to 9, **characterised in that** the metal-alkoxide coating material includes at least one alkoxide or one of several of the elements aluminium (Al), silicium (Si), tantalum (Ta), titanium (Ti), zirconium (Zr), hafnium (Hf) or yttrium (Y).

11. Printing template according to one of claims 4 to 10, **characterised in that** components containing fluorine, such as fluoroalkyl chains, are integrated into the metal-alkoxide hybrid polymer coating material.

12. Printing template according to one of the preceding claims 4 to 11, with the coating material being modified by installing surface-treated nano- or micro-scale particles.

13. Printing template according to one of the preceding claims 4 to 12, with the coating material being modified by installing non-surface-treated catalyst particles.

## Revendications

1. Procédé pour l'enduction d'un gabarit d'impression d'un procédé SMT, qui présente, dans son corps de gabarit métallique, des évidements correspondant à une structure d'impression prédéfinie, à travers lesquels une matière d'impression doit venir s'appliquer sur une plaque destinée à s'adjoindre par le bas au gabarit d'impression, **caractérisé par** un procédé de type sol-gel dans lequel on applique une matière de façonnement d'un matériau d'enduction à base d'un alcoxyde métallique via un procédé chimique par voie humide sur le corps de gabarit métallique (2a), ladite matière étant ensuite durcie par voie thermique, de telle sorte qu'il est muni d'une enduction mince (6) constituée d'un matériau d'enduction polymère hybride à base d'alcoxyde métallique manifestant une stabilité thermique et possédant une structure réticulée, le matériau d'enduction à base d'alcoxyde métallique présentant au moins une fraction organique qui est formée par un groupe alkyle ou par un groupe aryle ou par un groupe siloxane, si bien que l'on obtient une réduction de son énergie superficielle.

2. Procédé selon la revendication 1, **caractérisé en ce que** la matière d'impression à appliquer est une matière pâteuse d'apport de brasage ou une matière adhésive.

3. Procédé selon l'une quelconque des revendications précédentes, **caractérisé en ce que** l'application de la matière de façonnement a lieu par pulvérisation ou par immersion ou par noyage ou bien au rouleau ou au pinceau.

4. Gabarit d'impression d'un procédé SMT, qui présente, dans son corps de gabarit métallique, des évidements (3) correspondant à une structure d'impression prédéfinie, à travers lesquels une matière d'impression doit venir s'appliquer sur une plaque destinée à s'adjoindre par le bas au gabarit d'impression, **caractérisé en ce que** le corps de gabarit métallique (2a) possède une enduction mince (6), dont l'épaisseur est inférieure à 10 µm, constituée d'un matériau d'enduction polymère hybride à base d'alcoxyde métallique manifestant une stabilité thermique et possédant une structure réticulée, la structure réticulée comprenant des composants organiques et inorganiques.

5. Gabarit d'impression selon la revendication 4, **caractérisé en ce que** l'enduction (6) présente une énergie superficielle inférieure à 20 mN/m.

6. Gabarit d'impression selon l'une quelconque des revendications précédentes 4 ou 5, **caractérisé en ce que** l'allongement maximal (a) d'au moins un des évidements (3) du gabarit d'impression se situe entre 200 µm et 500 µm.

7. Gabarit d'impression selon l'une quelconque des revendications précédentes 4 à 6, **caractérisé en ce que** l'épaisseur (d) de l'enduction (6) est inférieure à 5 µm.

8. Gabarit d'impression selon l'une quelconque des revendications précédentes 4 à 7, **caractérisé par** un corps de gabarit (2a) en acier ou en nickel (Ni) ou encore en alliage de nickel.

9. Gabarit d'impression selon l'une quelconque des revendications précédentes 4 à 8, **caractérisé en ce que** l'enduction réticulée possède une fraction organique sur le polymère hybride, qui est choisie parmi le groupe comprenant un groupe alkyle, un groupe aryle et un groupe siloxane.

10. Gabarit d'impression selon l'une quelconque des revendications précédentes 4 à 9, **caractérisé en ce que** le matériau d'enduction à base d'alcoxyde métallique comprend au moins un alcoxyde d'un ou de plusieurs éléments choisis parmi l'aluminium (Al), le silicium (Si), le tantale (Ta), le titane (Ti), le zirconium (Zr), le hafnium (Hf) ou l'yttrium (Y).

11. Gabarit d'impression selon l'une quelconque des revendications 4 à 10, **caractérisé en ce que**, dans le matériau d'enduction polymère hybride à base d'alcoxyde métallique, sont incorporés des fractions fluorées telles que des chaînes fluoroalkyle.

12. Gabarit d'impression selon l'une quelconque des revendications précédentes 4 à 11, dans lequel le matériau d'enduction a été modifié par l'incorporation de particules nanométriques ou micrométriques ayant subi un traitement superficiel.

13. Gabarit d'impression selon l'une quelconque des revendications précédentes 4 à 12, dans lequel le matériau d'enduction a été modifié par l'incorporation de particules de catalyseur qui n'ont pas subi de traitement superficiel.
